# FASCICULE DE BREVET EUROPEEN

(11) **EP 0 792 382 B1**
(45) Date de publication et mention de la délivrance du brevet: **29.07.1998**
(21) Numéro de dépôt: 95940301.5
(22) Date de dépôt: 10.11.1995
(51) Int. Cl.: C23C 14/56, C23C 16/54, B01J 8/10, B22F 1/02

(54) **APPAREIL DE DEPOT SOUS VIDE RELATIF D'UN MATERIAU SUR DES PIECES EN VRAC**
VORRICHTUNG ZUR VAKUUMBESCHICHTUNG VON SCHÜTTGUT
APPARATUS FOR THE RELATIVE VACUUM DEPOSITION OF A MATERIAL ON BULK PARTS

(30) Priorité: 18.11.1994 FR 9414488
(43) Date de publication de la demande: 03.09.1997
(73) Titulaire: SURFACE ENGINEERING, 39300 Champagnole (FR)
(72) Inventeur: CATTENOT, Jean-Marc, F-39300 Cize (FR)
(74) Mandataire: Schmit, Christian Norbert Marie
(86) Numéro de dépôt international: FR9501485
(87) Numéro de publication internationale: WO9616198

(56) Documents cités:
- GB-A- 2 124 259
- US-A- 3 394 679
- US-A- 4 116 161
- US-A- 4 397 885
- PATENT ABSTRACTS OF JAPAN vol. 007 no. 034 (C-150) ,10 Février 1983 & JP,A,57 188678 (MATSUSHITA DENKI SANGYO KK) 19 Novembre 1982,

## Description

La présente invention concerne un appareil de dépôt sous vide relatif d'un matériau sur des pièces en vrac.

L'invention trouve une application particulièrement avantageuse dans le domaine des dépôts sous vide relatif selon les techniques connues par les sigles PVD (Physical Vapour Deposition) ou PACVD (Plasma Assisted Chemical Vapour Deposition) et PECVD (Plasma Enhanced Chemical Vapour Deposition). Ces techniques permettent de déposer des matériaux variés, tels que des métaux (aluminium, titane, cuivre, or), du carbone, des oxydes, des composés du titane (carbure, nitrure), etc, sur pratiquement tous les supports, notamment des métaux, le verre, la céramique, ainsi que des matériaux plastiques (ABS, polycarbonate, PMMA).

Les domaines d'application de l'invention sont très larges, que ce soit la réalisation de couches décoratives pour lunettes, montres, stylos, etc, le traitement pour outillage par dépôt d'une couche dure sur des outils de coupe ou des outils de frappe par exemple, ou encore certaines applications spéciales comme les revêtements de protection contre les corrosions, la fabrication de réflecteurs optiques, etc.

Quelle que soit la technique utilisée, PVD, PACVD ou PECVD, les appareils connus de dépôt sous vide relatif comportent une chambre dans laquelle est placée une ou plusieurs cathodes, éventuellement cathodes-magnétron en PVD, polarisées négativement par rapport à ladite chambre. Sont également prévus des moyens de maintien de la chambre sous un vide relatif d'un ou plusieurs agents gazeux. Ces moyens sont généralement constitués par une pompe à vide assurant le balayage de la chambre à partir d'une arrivée d'agents gazeux provenant d'un réservoir quelconque.

Dans le cas de la technique PVD, lesdits agents gazeux peuvent être un gaz neutre comme l'argon, auquel est ajouté au besoin un gaz réactif tel que l'oxygène, l'azote ou le méthane lorsque le matériau à déposer est un oxyde, un nitrure ou un carbure métallique, le métal étant produit par pulvérisation de la cathode sous l'effet du bombardement des ions de gaz neutre accélérés.

Les techniques PACVD et PECVD sont mises en oeuvre au moyen d'agents gazeux qui sont décomposés par une cathode en espèces ioniques susceptibles de réagir chimiquement avec le matériau constitutif des pièces à revêtir.

Il faut cependant remarquer que dans les appareils connus de dépôt sous vide relatif tels que ceux mentionnés plus haut, les pièces à traiter sont généralement tenues mécaniquement à l'intérieur de la chambre par des attaches qui, à l'issue du traitement, laissent sur lesdites pièces une trace caractérisée par l'absence de dépôt à l'endroit où lesdites attaches sont en contact avec les pièces.

Même s'il est parfois possible de faire en sorte que ladite trace se forme à un endroit sans inconvénient pour la pièce considérée, une deuxième opération de dépôt peut s'avérer nécessaire si l'on veut supprimer toute trace consécutive au masquage de la pièce par l'attache, ce que n'est d'ailleurs pas toujours faisable compte tenu des conditions de revêtement.

On peut également noter que la mise en place des pièces une à une par des attaches dans la chambre de traitement prend beaucoup de temps et contribue de ce fait à une augmentation du coût global de l'opération de dépôt. Ceci est particulièrement vrai lorsque les pièces à revêtir sont par exemple des maillons de bracelet qu'il faut engager sur un fil.

Le brevet américain US-A-4 116 161 tente de remédier à ces différents problèmes en proposant un appareillage de dépôt sous vide comprenant une enceinte, reliée à des moyens de mise sous vide et à l'intérieur de laquelle sont disposés horizontalement deux cylindres tournants destinés à agiter les pièces à traiter. Bien que ces cylindres soient montés inclinables afin de permettre l'évacuation des pièces après l'achèvement du processus de dépôt, leur position reste parfaitement horizontale durant toute la phase de vaporisation. Cette particularité entraîne malheureusement un brassage insuffisant des pièces qui ont tendance à glisser simplement le long de la paroi interne de chaque cylindre en rotation, sans pour autant se mélanger ou rouler sur elles-mêmes afin d'exposer avantageusement toutes leurs faces aux émissions ioniques. De plus, le positionnement spécifique des électrodes intégrant le métal à vaporiser, c'est-à-dire à l'extérieur des cylindres tournants, n'est pas propice à l'obtention d'un dépôt homogène.

Aussi, le problème technique à résoudre par l'objet de la présente invention est de proposer un appareil de dépôt d'un matériau sous vide relatif, appareil qui permettrait de réaliser un dépôt de matériau parfaitement uniforme sur les pièces à recouvrir, tout en évitant des manipulations fastidieuses liées à l'installation desdites pièces à l'intérieur de la chambre de traitement.

La solution au problème technique posé consiste, selon la présente invention, en un appareil de dépôt sous vide relatif d'un matériau sur des pièces en vrac, comprenant une chambre dans laquelle est placée au moins une cathode polarisée négativement par rapport à ladite chambre, et des moyens de maintien de la chambre sous un vide relatif d'au moins un agent gazeux, remarquable en ce que ladite chambre est montée rotative autour d'un axe incliné par rapport à l'horizontale à l'intérieur d'une enceinte portant lesdits moyens de maintien sous vide relatif, la chambre présentant une ouverture supérieure d'introduction des pièces en vrac et une ouverture inférieure d'évacuation desdites pièces après dépôt dudit matériau.

Ainsi, les pièces introduites en vrac dans l'appareil de dépôt conforme à l'invention sont agitées à l'intérieur de la chambre par le mouvement rotatif imprimé à cette dernière, ce qui contribue à obtenir une excellente homogénéité du dépôt sur les pièces.

L'efficacité d'agitation peut être considérablement augmentée lorsque, selon l'invention, ladite chambre comporte des barres longitudinales de retournement destinées à brasser les pièces en vrac pendant le dépôt dudit matériau.

Comme on le verra en détail plus loin, l'inclinaison de la chambre par rapport à l'horizontale permet une circulation des pièces en vrac sous la seule action de la gravité depuis leur introduction dans l'appareil jusqu'à leur récupération après dépôt, sans qu'il soit nécessaire d'utiliser un quelconque dispositif de convoyage.

On observera par ailleurs que, du fait du traitement en vrac des pièces, toute opération manuelle de mise en place individuelle desdites pièces dans la chambre est devenue totalement inutile.

L'appareil, objet de l'invention, présente également l'avantage de rendre possible le recouvrement par PVD, PACVD et PECVD des pièces de très petites tailles, comme des vis, alors que la mise en oeuvre de ces techniques est exclue avec les appareils de dépôt sous vide relatif actuellement connus car lesdites pièces ne peuvent y être tenues en raison de leurs faibles dimensions.

Deux modes de réalisation de l'appareil conforme à l'invention sont envisagés.

Selon un premier mode de réalisation, il est prévu que, pour un fonctionnement discontinu, la chambre est munie d'une plaque mobile d'obturation apte, d'une part, à retenir les pièces en vrac dans ladite chambre par obturation de ladite ouverture inférieure d'évacuation pendant le dépôt dudit matériau, et, d'autre part, à évacuer lesdites pièces après dépôt du matériau par dégagement de l'ouverture inférieure d'évacuation.

Dans un deuxième mode de réalisation, l'invention prévoit que, pour un fonctionnement continu, ladite enceinte comporte un conduit supérieur d'introduction des pièces en vrac dans ladite chambre et un conduit inférieur d'évacuation de la chambre desdites pièces après dépôt dudit matériau, chacun desdits conduits étant muni d'un orifice de pompage de l'air extérieur, destiné à isoler l'enceinte de l'atmosphère ambiante.

La description qui va suivre en regard des dessins annexés, donnés à titre d'exemples non limitatifs, fera bien comprendre en quoi consiste l'invention et comment elle peut être réalisée.

La figure 1 est une vue de côté d'un premier mode de réalisation d'un appareil de dépôt sous vide relatif conforme à l'invention, à fonctionnement discontinu.

La figure 2 est une vue de côté d'un deuxième mode de réalisation d'un appareil de dépôt sous vide relatif conforme à l'invention, à fonctionnement continu.

La figure 3 est une vue de face d'un appareil de dépôt sous vide relatif, objet de l'invention, montrant un dispositif de création d'un champ magnétique de focalisation.

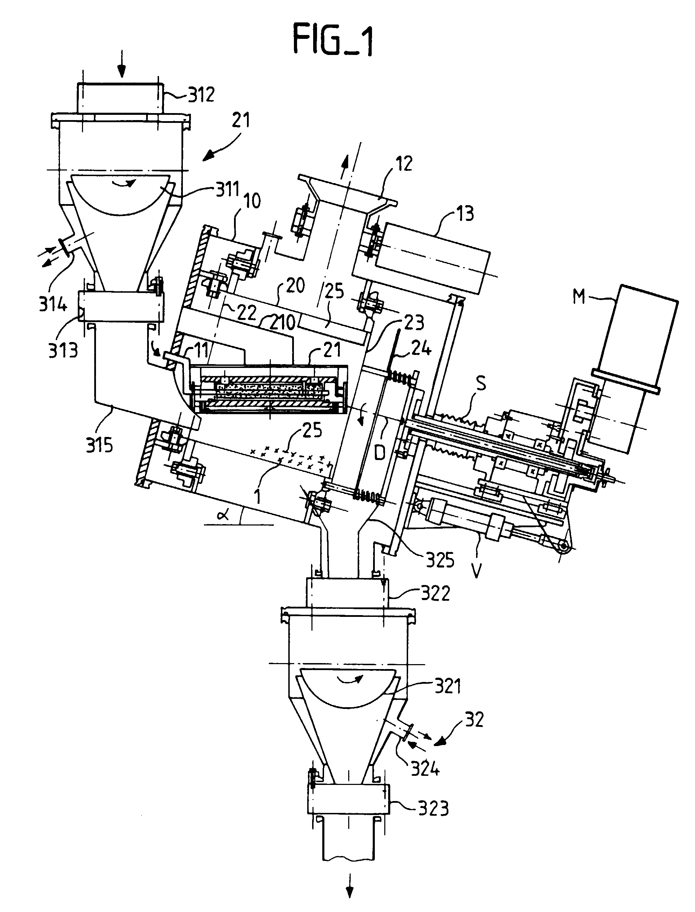

La figure 1 montre en vue de côté un appareil de dépôt sous vide d'un matériau sur des pièces 1 en vrac, fonctionnant selon un mode discontinu. Cet appareil comprend une enceinte 10 munie de moyens permettant de maintenir l'intérieur de ladite enceinte sous un vide relatif d'au moins un agent gazeux qui, comme rappelé plus haut, peut être un gaz neutre ou un gaz susceptible de réagir avec le matériau constituant les pièces 1 à traiter, le choix dudit agent gazeux dépendant de la technique de dépôt utilisée.

L'enceinte 10 renferme une chambre 20 dans laquelle est placée une cathode 21, ou une cathode-magnétron, polarisée négativement par rapport à ladite chambre 20 et destinée à effectuer, de façon classique, l'opération de dépôt dudit matériau sur les pièces 1. Il convient de remarquer que, dans le cas de la technique PECVD, la cathode peut être constituée par le support des pièces 1 à recouvrir

Ainsi que le montre la figure 1, la chambre 20 est montée rotative autour d'un axe D incliné d'un angle α par rapport à l'horizontale, ledit angle α pouvant être de l'ordre de 15° par exemple. Cette disposition a le double avantage de permettre un traitement en vrac des pièces 1, sans avoir besoin de les maintenir individuellement dans la chambre 10, et d'obtenir, en comparaison des appareils classiques, une bien meilleure homogénéité de dépôt, liée à l'agitation à laquelle sont soumises les pièces consécutivement au mouvement de rotation de la chambre 20.

D'autre part, du fait de l'inclinaison de ladite chambre 20 par rapport à l'horizontale, il est possible de faire circuler les pièces 1 en vrac à travers l'appareil, objet de l'invention, sous l'action de la seule gravité, notamment entre une ouverture supérieure 22 d'introduction à l'intérieur de la chambre 20 et une ouverture inférieure 23 d'évacuation à l'extérieur de ladite chambre en vue de leur récupération après dépôt dudit matériau.

Dans l'exemple donné à la figure 1, lesdits moyens de maintien sous vide relatif comprennent, d'une part, un tube 11 d'alimentation constitué de manière à permettre une injection de gaz de chaque côté de la cathode 21, et, d'autre part, une pompe à vide, non représentée, connectée à un orifice 12 de pompage. Une vanne 13 de réglage est prévue dans le but d'ajuster la pression de vide relatif dans l'enceinte 10 au cours du dépôt.

Dans le cadre de l'appareil à fonctionnement discontinu de la figure 1, on peut observer que la chambre 20 est muni d'une plaque mobile 24 d'obturation apte, d'une part, à retenir les pièces 1 en vrac dans ladite chambre par obturation de ladite ouverture inférieure 23 d'évacuation pendant l'opération de dépôt, et, d'autre part, à évacuer lesdites pièces 1 après dépôt du matériau par dégagement de ladite ouverture inférieure 23 d'évacuation.

Selon le mode de réalisation de la figure 1, le mouvement de ladite plaque mobile 24 d'obturation est obtenu à l'aide d'un vérin V entraînant également un équipage comprenant un moteur M de mise en rotation de la chambre 20 de dépôt, l'étanchéité au vide relatif étant assurée à l'aide du soufflet S.

La figure 1 montre également que la chambre 20 comporte des barres longitudinales 25 de retournement destinées à brasser les pièces 1 en vrac pendant le dépôt dudit matériau.

Signalons que des amortisseurs de choc peuvent être mêlés aux pièces 1 au moment de leur introduction dans l'appareil de l'invention, ceci dans le but de limiter les effets de détérioration susceptibles d'affecter la qualité du dépôt lorsque les pièces s'entrechoquent les unes contre les autres.

Comme l'illustre la figure 1, l'appareil de dépôt sous vide relatif de l'invention comporte un sas étanche 31 d'introduction par gravité des pièces 1 en vrac dans la chambre 20 à travers l'ouverture supérieure 22 d'introduction, et un sas étanche 32 de récupération desdites pièces évacuées de la chambre 20 également par gravité à travers l'ouverture inférieure 23 d'évacuation après dépôt dudit matériau et dégagement de la plaque mobile 24 d'obturation par actionnement du vérin V.

Plus précisément, les pièces 1 sont d'abord introduites dans un bol 311 du sas supérieur 31 d'introduction à travers une vanne 312 d'entrée, la vanne 313 de sortie du sas 31 étant fermée. Puis, après fermeture de ladite vanne 312 d'entrée, ledit sas 31 d'introduction est pompé à travers un orifice 314. Lorsque la chambre 20 de dépôt est prête à recevoir un nouveau lot de pièces, la vanne 313 de sortie est ouverte et le bol 311 contenant les pièces 1 est retourné de manière à amener lesdites pièces dans la chambre 20 par l'intermédiaire d'un coude 315 pénétrant dans l'enceinte 10 jusqu'au niveau de l'ouverture supérieure 22 de la chambre 20. La vanne 313 de sortie est alors refermée et de l'air est introduit dans le sas 31 par le même orifice 314 afin de permettre l'ouverture de la vanne 312 d'entrée et l'introduction d'un nouveau lot de pièces 1. Bien entendu, cette opération visant à alimenter en pièces la chambre 20 de traitement est réalisée en temps masqué lors du dépôt proprement dit.

Il en est de même pour le fonctionnement du sas 32 de récupération des pièces 1 après dépôt, avec un entonnoir 325 de collection des pièces au niveau de ouverture 23 d'évacuation, une vanne 322 d'entrée, une vanne 323 de sortie, un bol 321 basculant et un orifice 324 de pompage ou d'arrivée d'air.

On peut voir sur la figure 1 que la cathode 21 est maintenue dans l'enceinte 10 par un porte-cathode 210 se présentant comme un tube creux, étanche au vide et s'ouvrant vers l'extérieur de ladite enceinte de manière à permettre le passage de moyens d'alimentation de ladite cathode 21 en eau et en énergie électrique.

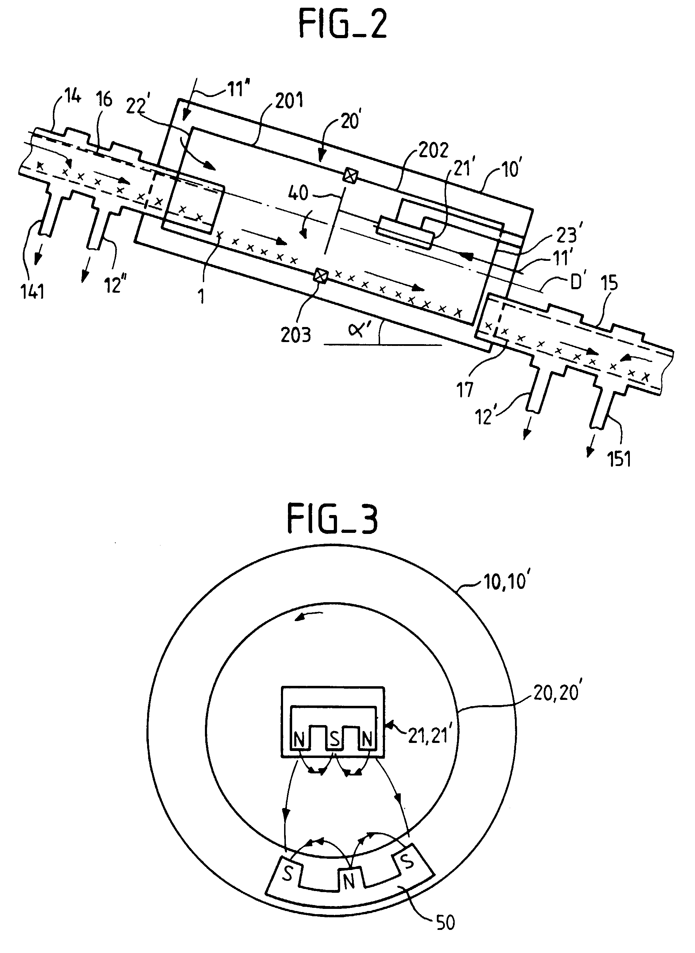

L'appareil à fonctionnement continu représenté sur la figure 2 comporte globalement les mêmes éléments que l'appareil à fonctionnement discontinu de la figure 1, à savoir une enceinte 10' à vide relatif contenant une chambre 20' de dépôt dans laquelle est disposée une cathode 21'. Ladite chambre 20' est montée rotative autour d'un axe D' incliné d'un angle α' par rapport à l'horizontale, et présente une ouverture supérieure 22' d'introduction des pièces 1 en vrac et une ouverture inférieure 23' d'évacuation desdites pièces après dépôt du matériau.

Dans le mode de la réalisation de la figure 2, la chambre 20' est divisée, d'une part, en un compartiment supérieur 201 de décapage des pièces 1, et, d'autre part, en un compartiment 202 de dépôt du matériau sur lesdites pièces. Lesdits compartiments 201 et 202 sont mécaniquement solidaires dans leur mouvement de rotation, mais électriquement isolés par un isolant 203, et partiellement séparés par un élément 40 de cloison fixe, afin que chaque compartiment soit maintenu sous un vide relatif d'un agent gazeux respectif : agent gazeux de décapage pour le compartiment supérieur 201, agent gazeux de dépôt pour le compartiment inférieur 202.

L'enceinte 10' de l'appareil de la figure 2 comporte également un conduit supérieur 14 d'introduction en continu des pièces 1 en vrac dans le compartiment supérieur 201 de la chambre 20' et un conduit inférieur 15 d'évacuation, également en continu, desdites pièces après dépôt dudit matériau dans le compartiment inférieur 202 de la chambre 20', chacun desdits conduits étant muni d'un orifice de pompage, respectivement 141, 151, de l'air extérieur, destiné à isoler l'enceinte 10' de l'atmosphère ambiante.

Les conduits 14 et 15 portent également des orifices 12", 12' de pompage assurant, avec des tubes 11",11' d'alimentation en agent gazeux respectifs, un vide relatif dans chacun des compartiments 201,202 de la chambre 20'.

Des grilles 16 et 17 placées dans les conduits 14 et 15 évitent aux pièces 1 de tomber dans les différents orifices de pompage.

La figure 3 montre comment il est possible de focaliser le plasma produit par les cathodes 21,21' des appareils des figures 1 et 2 afin d'augmenter le bombardement électronique et l'échauffement des pièces. A cet effet, un champ magnétique supplémentaire est crée à l'aide de pièces polaires 50 disposées entre l'enceinte 10,10' à vide relatif et la chambre 20,20' de dépôt, en regard des pièces polaires de la cathode 21,21'.

## Revendications

1. Appareil de dépôt sous vide relatif d'un matériau sur des pièces (1) en vrac, comprenant une chambre (20;20') dans laquelle est placée au moins une cathode (21;21') polarisée négativement par rapport à ladite chambre, et des moyens (11,12;11',12',11",12") de maintien de la chambre (20;20') sous un vide relatif d'au moins un agent gazeux, caractérisé en ce que ladite chambre (20;20') est montée rotative autour d'un axe incliné (D;D') par rapport à l'horizontale à l'intérieur d'une enceinte (10;10') portant lesdits moyens de maintien sous vide relatif, la chambre (20;20') présentant une ouverture supérieure (22,22') d'introduction des pièces (1) en vrac et une ouverture inférieure (23;23') d'évacuation desdites pièces après dépôt dudit matériau.

2. Appareil selon la revendication 1, caractérisé en ce que ladite chambre (20) comporte des barres longitudinales (25) de retournement destinées à brasser les pièces (1) en vrac pendant le dépôt dudit matériau.

3. Appareil selon l'une des revendications 1 ou 2, caractérisé en ce que, pour un fonctionnement discontinu, la chambre (20) est munie d'une plaque mobile (24) d'obturation apte, d'une part, à retenir les pièces (1) en vrac dans ladite chambre par obturation de ladite ouverture inférieure (23) d'évacuation pendant le dépôt dudit matériau, et, d'autre part, à évacuer lesdites pièces (1) après dépôt du matériau par dégagement de l'ouverture inférieure (23) d'évacuation.

4. Appareil selon la revendication 3, caractérisé en ce qu'il comporte un sas étanche (31) d'introduction par gravité des pièces (1) en vrac dans ladite chambre (20) à travers l'ouverture supérieure (22) d'introduction, et un sas étanche (32) de récupération desdites pièces (1) évacuées de la chambre (20) par gravité à travers l'ouverture inférieure (23) d'évacuation après dépôt dudit matériau et dégagement de ladite plaque mobile (24) d'obturation.

5. Appareil selon l'une des revendications 1 ou 2, caractérisé en ce que, pour un fonctionnement continu, ladite enceinte (10') comporte un conduit supérieur (14) d'introduction des pièces (1) en vrac dans ladite chambre (20') et un conduit inférieur (15) d'évacuation de la chambre (20') desdites pièces (1) après dépôt dudit matériau, chacun desdits conduits (14,15) étant muni d'un orifice (141,151) de pompage de l'air extérieur, destiné à isoler l'enceinte (10') de l'atmosphère ambiante.

6. Appareil selon la revendication 5, caractérisé en ce que ladite chambre (20') est divisée en un compartiment supérieur (201) de décapage des pièces (1) en vrac et un compartiment inférieur (202) de dépôt du matériau sur lesdites pièces, lesdits compartiments étant mécaniquement solidaires en rotation, isolés électriquement et partiellement séparés au moyen d'un élément (40) de cloison fixe.

7. Appareil selon l'une quelconque des revendications 1 à 6, caractérisé en ce que des pièces polaires (50) sont disposées entre l'enceinte (10,10') et la chambre (20,20') en regard de la (21) ou des cathodes.

## Patentansprüche

1. Vorrichtung zur Vakuumabscheidung eines Materials auf Schüttgut (1), die eine Kammer (20; 20'), in der wenigstens eine gegenüber der Kammer negativ polarisierte Kathode (21; 21') angeordnet ist, und Mittel (11, 12; 11', 12'; 11", 12") zum Halten der Kammer (20; 20') unter einem Vakuum bezüglich wenigstens eines gasförmigen Stoffes aufweist,
daduch gekennzeichnet, daß
die Kammer (20; 20') um eine Achse (D; D') drehbar montiert ist, die zur Horizontalen im Inneren eines Behälters (10; 10'), der die Mittel zum Halten unter relativen Vakuum trägt, geneigt ist, und die Kammer (20; 20') eine obere Offnung (22, 22') zur Einführung des Schüttguts (1) und eine untere Öffnung (23, 23') zur Entlee rung des Schüttguts nach Abscheidung des Materials aufweist.

2. Vorrichtung nach dem Anspruch 1, dadurch gekennzeichnet, daß die Kammer (20) Längswendestangen (25) aufweist, die zum Durchrühren des Schüttguts (1) während der Abscheidung des Materials bestimmt sind.

3. Vorrichtung nach einem der Ansprüche 1 oder 2, dadurch gekennzeichnet, daß die Kammer (20) für einen diskontinuierlichen Betrieb mit einer beweglichen Verschlußplatte (24) ausgerüstet ist, die sich einerseits zum Zurückhalten des Schüttguts (1) in der Kammer durch Verschluß der unteren Entleerungsöffnung (23) während der Abscheidung des Materials und andererseits zur Entleerung des Schüttguts (1) nach Abscheidung des Materials durch Freigabe der unteren Entleerungsöffnung (23) eignet.

4. Vorrichtung nach dem Anspruch 3, dadurch gekenzeichnet, daß sie eine dichte Schleuse (31) zur Einführung des Schüttguts (1) durch Schwerkraft in die Kammer (20) durch die obere Einführungsöffnung (22) und eine dichte Schleuse (32) zur Erfassung des Schüttguts (1) aufweist, das durch Schwerkraft durch die untere Entleerungsöffnung (23) nach Abscheidung des Materials und Freigabe der beweglichen Verschlußplatte (24) entleert wurde.

5. Vorrichtung nach einem der Ansprüche 1 oder 2, dadurch gekennzeichnet, daß der Behälter (10') für einen kontinuierlichen Betrieb eine obere Leitung (14) zur Einführung des Schüttguts (1) in die Kammer (20') und eine untere Leitung (15) zur Entleerung des Schüttguts (1) aus der Kammer (20') nach Abscheidung des Materials aufweist, wobei jede der Leitungen (14, 15) mit einer Öffnung (141, 151) zum Abpumpen der Außenluft zwecks Isolierung des Behälters (10') von der Umgebungsatmosphäre ausgerüstet ist.

6. Vorrichtung nach dem Anspruch 5, dadurch gekennzeichnet, daß die Kammer (20') in ein oberes Abteil (201) zum Beizen des Schüttguts (1) und ein unteres Abteil (202) zur Abscheidung des Materials auf dem Schüttgut unterteilt ist, welche Abteile mechanisch einstückig in Rotation, elektrisch isoliert und mittels eines festen Zwischenwandelements (40) teilweise getrennt sind.

7. Vorrichtung nach irgendeinem der Ansprüche 1 bis 6, dadurch gekennzeichnet, daß Polstücke (50) zwischen dem Behälter (10, 10') und der Kammer (20, 20') gegenüber der Kathode (21) oder den Kathoden angeordnet sind.

## Claims

1. A device for depositing a material onto batches of items under relative vacuum, comprising a chamber (20; 20') in which at least one cathode (21; 21') is placed, negatively polarised relative to said chamber, and means (11, 12; 11', 12'; 11", 12") for retaining the chamber (20; 20') under a relative vacuum in the presence of at least one gaseous agent, characterised in that said chamber (20; 20') is mounted so that it can rotate about an axis (D; D') inclined relative to the horizontal inside an enclosure (10; 10') which supports said means for retaining a relative vacuum, the chamber (20; 20') having an upper opening (22; 22') for feeding in batches of items (1) and a lower opening (23; 23') for discharging said items after said material has been deposited.

2. A device as claimed in claim 1, characterised in that said chamber (20) has longitudinal turning bars (25) designed to agitate the batches of items (1) whilst said material is being deposited.

3. A device as claimed in one of claims 1 or 2, characterised in that in order to allow discontinuous operation, the chamber (20) is fitted with a mobile closer plate (24) designed to retain the batches of items (1) said chamber, on the one hand, by closing off said lower discharge opening (23) whilst said material is being deposited and, on the other, for discharging said items (1) after the material has been deposited by uncovering the lower discharge opening (23).

4. A device as claimed in claim 3, characterised in that it has a sealed lock chamber (31) for feeding the batches of items (1) into said chamber (20) through the upper inlet opening (22) by gravity and a sealed lock chamber (32) for retrieving said items (1) discharged from the chamber (20) through the lower discharge opening (23) by gravity after said material has been deposited and releasing said mobile closer plate (24).

5. A device as claimed in one of claims 1 or 2, characterised in that in order to allow continuous operation, said enclosure (10') has an upper passage (14) for feeding batches of items (1) into said chamber (20') and a lower passage (15) for discharging said items (1) from the chamber (20') after said material has been deposited, each of said passages (14, 15) being provided with an orifice (141, 151) for pumping external air in order to isolate the enclosure (10') from the ambient atmosphere.

6. A device as claimed in claim 5, characterised in that said chamber (20') is divided into an upper compartment (201) for cleaning the batches of items (1) and a lower compartment (202) for depositing the material on said items, said compartments being mechanically joined in rotation, electrically insulated and partially separated by means of a fixed partition member (40).

7. A device as claimed in any one of claims 1 to 6, characterised in that the polar components (50) are arranged between the enclosure (10, 10') and the chamber (20, 20') facing the cathode or cathodes (21).
